Europäisches Patentamt

European Patent Office

Office européen des brevets

(19)

(11) **EP 0 921 528 B1**

(12) **EUROPEAN PATENT SPECIFICATION**

(45) Date of publication and mention
of the grant of the patent:
**19.10.2005 Bulletin 2005/42**

(51) Int Cl.⁷: **G11C 29/00**

(21) Application number: **98303712.8**

(22) Date of filing: **12.05.1998**

(54) **A memory device using direct access mode test and a method of testing the same**

Speicherschaltung mit DMA Prüfung und sein Prüfverfahren

Circuit de mémoire utilisant un test avec DMA et procédé de test

(84) Designated Contracting States:
**DE FR GB**

(30) Priority: **03.12.1997 KR 9765539**

(43) Date of publication of application:
**09.06.1999 Bulletin 1999/23**

(73) Proprietor: **SAMSUNG ELECTRONICS CO., LTD.**
**Suwon-city, Kyungki-do (KR)**

(72) Inventors:
• **Chai, Joon-Wan**
**Bundang-gu, Seongnam-city, Kyungki-do (KR)**
• **Kyung, Kye-Hyun**
**Kwonsun-gu, Suwon-city, Kyungki-do (KR)**

(74) Representative: **Ertl, Nicholas Justin et al**
**Elkington and Fife LLP,**
**Prospect House,**
**8 Pembroke Road**
**Sevenoaks, Kent TN13 1XR (GB)**

(56) References cited:
**US-A- 5 469 445          US-A- 5 521 870**
**US-A- 5 668 815**

• **PATENT ABSTRACTS OF JAPAN vol. 097, no.
012, 25 December 1997 & JP 09 213072 A (NEC
CORP), 15 August 1997**

## Description

The present invention relates to a semiconductor memory device, and more particularly, to a semiconductor memory device capable of testing memory cells by a direct access mode test method, and to a method of testing the same.

In general, for a semiconductor memory device, DC, AC and function are tested using a measuring system. The function test is for determining whether cells and circuits in a memory chip operate normally. By the function test, original predetermined data is written to a memory, the data is read, and the read data is compared to the original data.

Recently-developed high speed memory devices are unlike conventional dynamic random access memories (DRAMs) in that they include an input and output portion for receiving external signals, an interface logic portion for receiving commands generated by the input and output portion and decoding the received commands, and a DRAM core portion. The function of the high speed memory device DRAM core portion is tested typically by the direct access mode test method. By the direct access mode test, test signals generated by a low-frequency test apparatus bypass the interface logic to contact directly with the memory cells. Accordingly, only necessary signals are received, without passing through the interface logic, to test the memory cell, to thereby increase test speed.

However, in a conventional direct access mode test method, one data output pin requires one test pin of a test apparatus. Accordingly, the number of high speed memory devices capable of being simultaneously tested is limited, when the number of test pins per test apparatus test pins is limited.

To test a high speed memory device of x9, i.e., having 9 data output pins, in a test apparatus having 144 test pins, 16 high speed memory devices can be simultaneously tested. Or, 8 high speed memory devices of x16 can be simultaneously tested. Therefore, as the number of data output pins increases, fewer high speed memory devices can be simultaneously tested, thereby increasing the time for testing various memory devices.

US 5,521,870 describes a semiconductor memory device, on which the preamble of claim 1 is based, using a coincidence detection circuit. Data from memory blocks is output to serial registers which are connected in series to feed the data to the coincidence detection circuit for testing.

According to the first aspect of the invention, a semiconductor memory device comprising: N memory blocks (10,20), where N is a natural number; N pipe line blocks (52,62) for receiving a multiplicity of data output (RWD1...RWD8) in parallel by the memory blocks, to serially output the data; N output drivers (14) for transmitting data output from the pipe line blocks to data output pins (DQ1,DQ2); and at least one test mode controller (40) for connecting output lines of an ith pipe line block (52) to input lines of an (i+1)th pipe line block (62), where i is a natural number smaller than N, such that data output by the ith pipe line block (52) is received by said (i+1)th pipe line block (62), synchronized with a test clock (TCLK), when the memory device enters a direct access test mode; wherein each of the pipe line blocks (52,62) comprises: a plurality of odd latch units (LAT1, LAT3, LAT5, LAT7) connected in series; a plurality of even latch units (LAT2, LAT4, LAT6, LAT8) connected in series; and characterized by comprising a selector (54,64) receiving in parallel a data output of the odd latch units and a data output of the even latch units, to selectively output data of the odd latch units or the even latch units to a corresponding output driver (14) on the basis of the state of the test clock.

Each of the pipe line blocks includes a multiplicity of latches which are connected in series, for latching and outputting data output by the memory blocks, or a plurality of latch units for latching and outputting data of the memory blocks, in which odd latch units and even latch units are connected in parallel: and a selector for receiving data output by the odd and even latches to selectively output the received data.

The invention also relates to a use of the above semiconductor memory device as set out in claim 11.

In the present invention, data latched to N pipe line blocks is output through one data output pin, thereby reducing the number of data output pins used for a direct access mode test to 1/N. Accordingly, more high speed memory devices can be simultaneously tested using a test apparatus.

Examples of the present invention will now be described in detail with reference to the accompanying drawings, in which:

FIG. 1 is a block diagram showing an input and output circuit of a high speed memory device;
FIG. 2 is a block diagram showing an embodiment of an input and output circuit of a high speed memory device according to the present invention;
FIG. 3 is a circuit diagram of an example of the pipe line block of FIG. 2;
FIG. 4 is a timing diagram showing signals driving the memory device of FIG. 2 and output data responding to the signals; and,
FIG. 5 is a block diagram showing an input and output circuit of a high speed memory device.

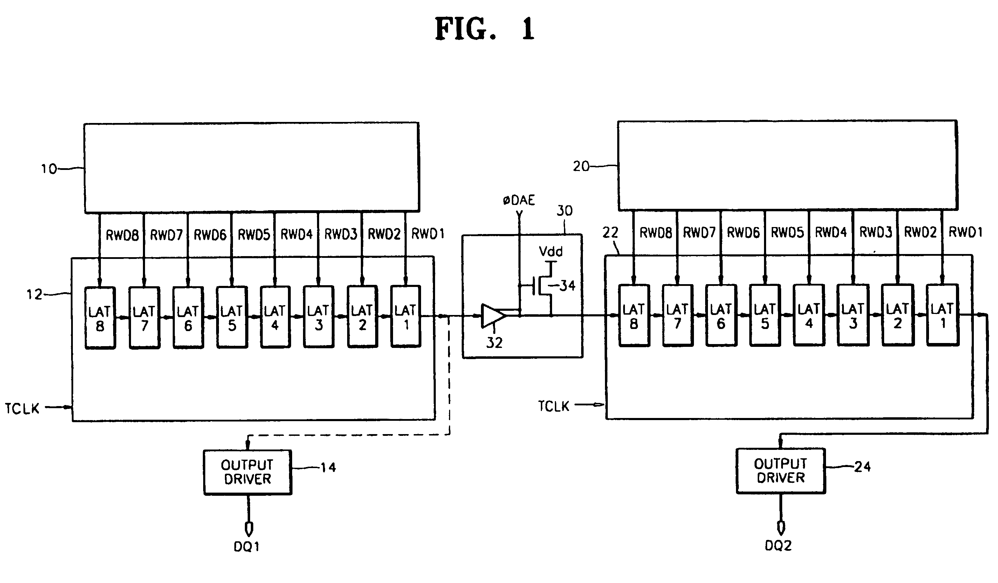

Referring to FIG. 1, an input and output circuit of a high speed memory device includes two memory blocks 10 and 20. The high speed semiconductor memory device of FIG. 1 includes first and second pipe line blocks 12 and 22 for receiving parallel data RWD1 ~ RWD8 output from the first and second memory blocks 10 and 20 and outputting them serially, and a test mode control means 30 for connecting an output line of the first pipe line block 12 to an input line of the second pipe line block 22 when the memory device enters a direct access test mode. Also, the high speed memory device includes output drivers 14 and 24 for receiving data output from the pipe line blocks 12 and 22 to and transmitting it to data output pins DQ1 and DQ2.

Each of the first and second pipe line blocks 12 and 22 includes a multiplicity of latch units LAT1 ~ LAT8, which receive the data RWD1 ~ RWD8 output from the memory blocks 10 and 20.

The test mode control means 30 is controlled by a test mode control signal ΦDAE activated when the memory device enters the direct access test mode. The test mode control means 30 connects an output line of the first pipe line block 12 to an input line of the second pipe line block 22 in the direct access test mode, and connects output lines of the pipe line blocks 12 and 22 to output drivers 14 and 24, respectively, in a normal mode. The test mode control means 30 may include a switch 32 controlled by the test mode control signal ΦDAE, e.g., a tri-state buffer having no affect on other circuits, or a transmission gate. Preferably, the test mode control means 30 further includes a transistor 34 turned on when the test mode control signal ΦDAE is inactive to supply a constant voltage to each latch of the second pipe line block 22 in the normal mode. The transistor 34 may be a PMOS transistor having a source connected to a power supply voltage Vdd and a drain connected to an input line of the second pipe line block 22. Although not shown, the transistor 34 may also be an NMOS transistor having a source connected to a ground and a drain connected to an input line of the second pipe line block 22.

When the memory device of FIG. 1 enters the direct access test mode, the test mode control signal ΦDAE is activated to 'high' and the switch 32 is turned on, to thereby form a data path on which an output line of the first pipe line block 12 is connected to an input line of the second pipe line block 22.

The data sequentially generated by the first pipe line block 12 is transmitted to the second pipe line block 22 through the test mode control means 30, and output through the second data output pin DQ2 arranged in the second pipe line block 22. That is, in the direct access test mode, 16 data units latched in the first and second pipe line blocks 12 and 22 are sequentially output through the second data output pin DQ2 arranged in the second pipe line block 22.

However, in a normal mode, the test mode control signal ΦDAE is deactivated to 'low' and the switch 32 is turned off. Thus, data generated by the two pipe line blocks 12 and 22 are output through the output drivers 14 and 24 and the data output pins DQ1 and DQ2, respectively. In other words, in the normal mode, 8 data units are sequentially output by each of the two data output pins DQ1 and DQ2.

The data path in the conventional direct access test mode is identical to that in the normal mode, so that the two data output pins DQ1 and DQ2 are used to output 16 data units. Accordingly, the number of data output pins used for the memory device of the present invention having two pipe line blocks is reduced to ½.

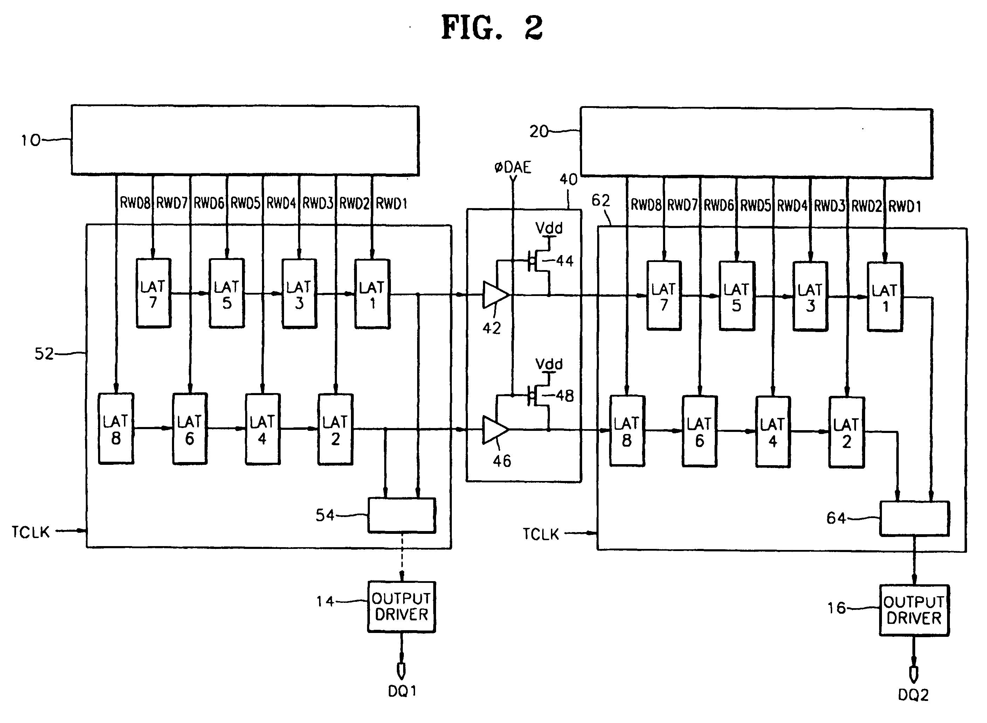

Referring to FIG. 2, the embodiment is the same as above except that the odd latches LAT1, LAT3, LAT5 and LAT7 of the pipe line block and even latches LAT2, LAT4, LAT6 and LAT8 thereof are arranged in parallel to increase data output speed. The same reference numerals as those of FIG. 1 represent the same elements.

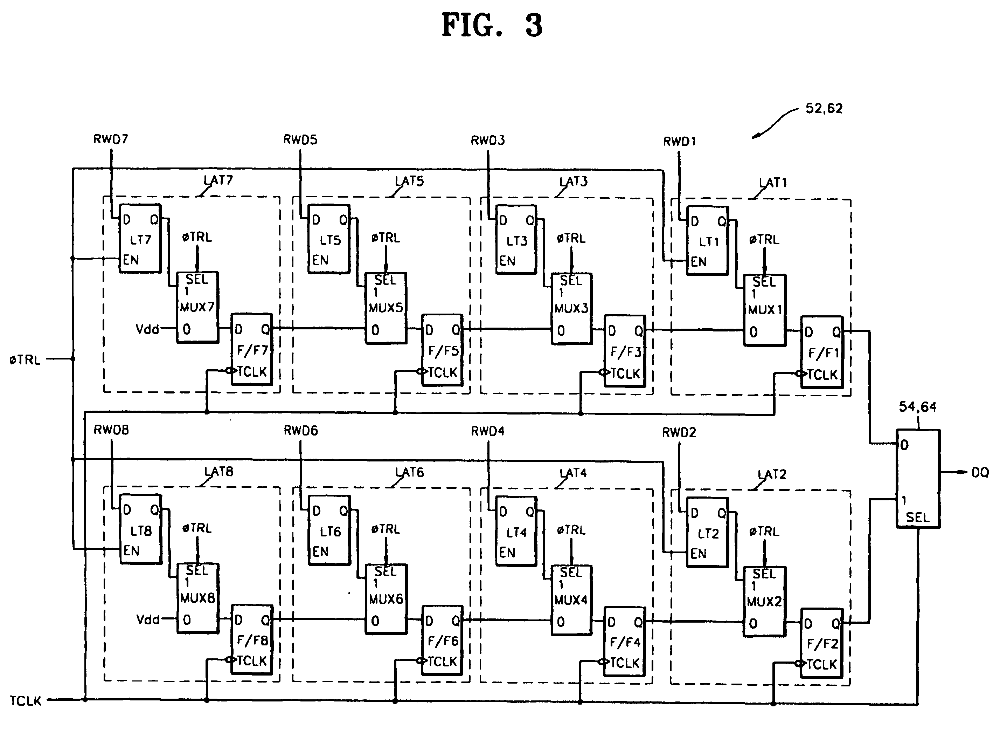

As shown in FIG. 2, each of the pipe line blocks 52 and 62 includes a plurality of latch units LAT1 ~ LAT8, and one select means 54 or 64 controlled by a test clock TCLK. The odd latch units, e.g., first, third, fifth and seventh latch units LAT1, LAT3, LAT5 and LAT7. are connected in series, and the even latches, e.g., second, fourth, sixth and eighth latches LAT2, LAT4, LAT6 and LAT8 are connected in series, and the outputs of the odd and even latch units are input in parallel the select means 54 and 64. Each of the select means 54 and 64 preferably includes a multiplexer for selectively outputting data of the odd latch units or the even latch units on the basis of the state of the test clock TCLK. A circuit diagram of an example of the pipe line blocks 52 and 62 is shown in FIG. 3.

A test mode control means 40 according to the embodiment of the present invention is controlled by the test mode control signal ΦDAE like in the memory device of Fig.1, and connects the pipe line blocks when the memory device operates in the direct access test mode, and disconnects the pipe line blocks when normally operating.

The test mode control means 40 is controlled by the test mode control signal ΦDAE, and includes switches 42 and 46 connected in series with the odd and even latch units, respectively. Here, the switches may be tri-state buffer, or transmission gates. The test mode control means 40 preferably includes transistors 44 and 48 turned-on by deactivation of the test mode control signal ΦDAE to apply a predetermined voltage to the latch units of the second pipe line block 62, in the normal mode.

When the memory device of FIG. 2 enters the direct access test mode, the test mode control signal ΦDAE is activated, and the switches 42 and 46 are turned on. Accordingly, two output lines of the first pipe line block 52 are connected to two input lines of the second pipe line block 62. Each two data units sequentially output from the first pipe line block 52 are input to the second pipe line block 62 through the test mode control means 40, and subsequent data is selectively output through the latch units of the second pipe line block 62 and the select means 64. That is, in the direct access test mode, 16 data units latched in the first and second pipe line blocks 52 and 62 are sequentially output by a data output pin DQ2 arranged in the second pipe line block 62. At this time, each two data units are shifted to an adjacent latch unit synchronized with the test clock TCLK, and the select means 62 is controlled by the test clock TCLK of logic 'high' and logic 'low', so that two data units are output every cycle of the test clock TCLK. Accordingly, the data output speed is higher than that of the memory device of Fig.1 in which one data unit is output every cycle of the test clock. That is, 16 data units synchronized with the test clock TCLK are output in 8 periods by the second embodiment and in 16 periods by the memory device of Fig.1

When the memory device of FIG. 2 operates in a normal mode, the switches 42 and 46 are turned off, and data generated by the two pipe line blocks 52 and 62 is output through output drivers 14 and 24 and the data output pins DQ1 and DQ2, respectively.

Referring to FIG. 3, the pipe line blocks 52 and 62 according to the second embodiment of the present invention have the same structure, and each of the pipe line blocks includes a multiplicity of latch units LAT1 ~ LAT8 and one select means 54 or 64 controlled by the test clock TCLK.

The latch units LATI ~ LAT8. respectively include latches LT1 ~ LT8 for storing data RWD1 ~ RWD8 received by the memory blocks 10 and 20 of FIG. 2 and outputting the stored data, multiplexers MUX1 ~ MUX8 for selectively outputting data generated by the latches LT1 ~ LT8 or data input from adjacent latches, and flipflops F/F1 ~ F/F8 for synchronizing the data generated by the multiplexers MUX1 ~ MUX8 with the test clock TCLK and outputting the synchronized data. The latches LT1 ~ LT8 may be D-flipflops activated by a test read signal ΦTRL. Each of the multiplexers MUX1 ~ MUX8 includes two input terminals 1 and 0 and a select terminal SEL which receives the test read signal ΦTRL. An output signal of the latch LT1 ~ LT8 and an output signal of the adjacent latch unit LAT1 ~ LAT8 are received by the two input terminals 1 and 0. For example, when the test read signal ΦTRL is logic 'high', data stored in the latch is received by the flipflops F/F1 ~ F/F8, and when the test read signal ΦTRL is logic 'low', data stored in an adjacent latch unit is applied to the flipflop. The flipflops F/F0 ~ F/F7 may be the D-flipflops, which determine the next state by an input value 'D'.

The test clock TCLK is received by the select line SEL of the select means 54 and 64, so that odd data and even data are selectively generated according to the state of the test clock TCLK. When the test read signal ΦTRL is activated and a first input test clock TCLK is logic 'low', the data RWD1 stored in the first latch LAT1 is output, and when logic 'high', the data RWD2 stored in the second latch LAT2 is output. Accordingly, the two data units RWD1 and RWD2 are sequentially generated within one cycle of the test clock TCLK.

In a normal mode, preferably, a predetermined voltage used for the memory, e.g., a supply voltage Vdd or ground voltage Vss, is applied to the '0' input terminals of the seventh and eighth multiplexers MUX7 and MUX8, and outputs of all flipflops F/F1 ~ F/F8 are constantly maintained at the time at which output of data RWD1 ~ RWD8 is finished. However, in the direct access test mode and in the second pipe line block 62, the data RWD1 and RWD2 generated by the first and second flipflops F/F1 and F/F2 of the first pipe line block 52 is received by the '0' input terminals of the seventh and eighth multiplexers MUX7 and MUX8.

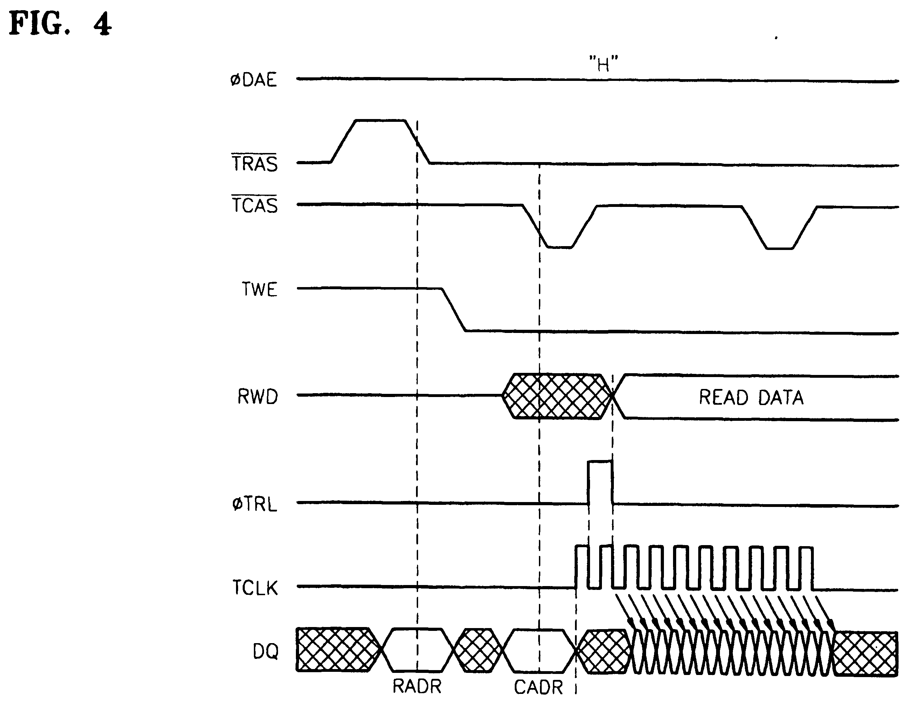

Referring to FIG. 4, when the memory device enters a direct access test mode to activate the test mode control signal ΦDAE to logic 'high', and a row address strobe signal $\overline{TRAS}$ is activated to logic 'low', the row address signal RADR is received. And when a write enable signal TWE is deactivated to logic 'low', and a column address strobe signal $\overline{TCAS}$ is activated to logic 'low', the column address signal CADR is received. When the test read signal ΦTRL is activated to logic 'high' in response to the $\overline{TCAS}$, data is transmitted from the memory blocks 10 and 20 to the pipe line blocks 52 and 62. And when the test read signal ΦTRL falls to logic 'low', data is sequentially generated synchronized with the rising and falling edges of the test clock TCLK. Operation of the memory devices of FIGS. 2 and 3 will be described with reference to FIG. 4.

When the memory device of FIG. 2 enters the direct access test mode, the test mode control signal ΦDAE is activated to logic 'high' to thereby turn on the switches 42 and 46 of the test mode control means 40. Accordingly, two output lines of the first pipe line block 52 are connected to two input lines of the second pipe line block 62. When the $\overline{TRAS}$ signal is activated to 'low' and the write enable signal is deactivated to 'low', and the $\overline{TCAS}$ is input, the data RWD0 ~ RWD8 is output from the memory blocks 10 and 20. The output data is transmitted to the latches LT1 ~ LT8 according to the activation of the test read signal ΦTRL and selected by the multiplexers MUX1 ~ MUX8 to be input to the flipflops F/F1 ~ F/F8.

Then, when the test read signal ΦTRL and the test clock TCLK are transited to logic 'low', the data input as flipflops F/F1 ~ F/F8 is transmitted to adjacent multiplexers MUX1 ~ MUX8, and data stored in the adjacent flipflops is input to the flipflops. For example, when the test read signal ΦTRL is 'high', the data RWD1 and RWD2 input to the first and second latches LT1 and LT2 is transmitted to the first and second flipflops. The data RWD1 and RWD2 is transmitted to the select means 54 and 64, and sequentially output synchronized with the falling and rising edges of the test clock TCLK. That is, the odd data is output at the falling edge of the test clock TCLK, and the even data is output at the rising edge thereof. Also, 16 units of data are generated over 8 cycles of the test clock TCLK.

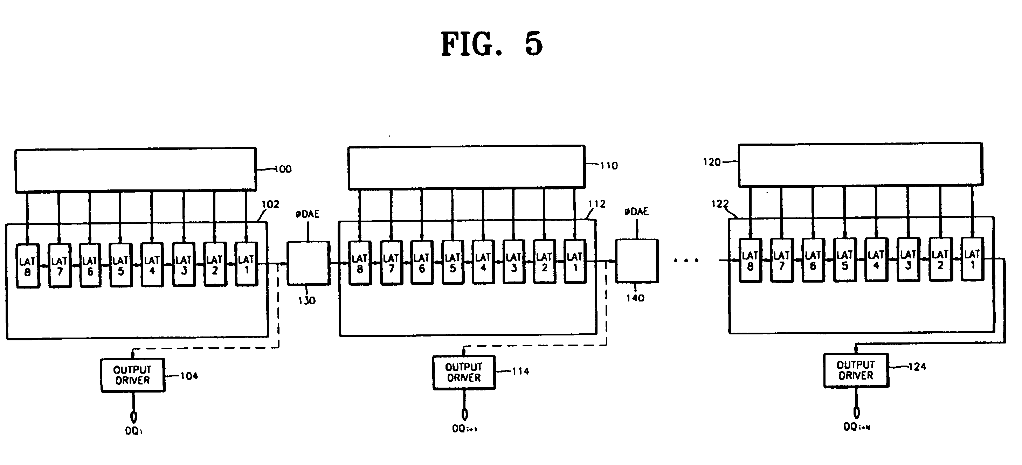

In FIG. 5, the arrangement is the same as that of Fig. 11 except that it has i+N pipe line blocks.

The high speed semiconductor memory device according to Fig. 5 includes i+N memory blocks 100, 110 and 120, i+N pipe line blocks 102, 112 and 122, i+N-1 test mode control means 130 and 140, and output drivers 104, 114 and 124 for receiving data output from the pipe line blocks 102, 112 and 122 and outputting the received data using data output pins $DQ_i$, $DQ_{i+1}$ and $Dq_{i+N}$, respectively.

In a direct access test mode, data input to each of the pipe line blocks is output through an (i+N)th data output pin Dqi+N. Thus, the number of data output pins used in a memory device having i+N pipe line blocks is reduced to 1/i+N.

In the present invention, fewer data output pins are used for the direct access mode test. Accordingly, more high speed memory devices can be simultaneously tested, to thereby increase operational efficiency of the test apparatus.

## Claims

1. A semiconductor memory device comprising:

   N memory blocks (10,20), where N is a natural number;
   N pipe line blocks (52,62) for receiving a multiplicity of data output (RWD1...RWD8) in parallel by the memory blocks, to serially output the data;
   N output drivers (14) for transmitting data output from the pipe line blocks to data output pins (DQ1,DQ2); and

   at least one test mode controller (40) for connecting an output line of an ith pipe line block (52) to an input line of an (i+1)th pipe line block (62), where i is a natural number smaller than N, such that data output by the ith pipe line block (52) is received by said (i+1)th pipe line block (62), synchronized with a test clock (TCLK), when the memory device enters a direct access test mode;
   wherein each of the pipe line blocks (52,62) comprises:

   a plurality of odd latch units (LAT1, LAT3, LAT5, LAT7) connected in series;
   a plurality of even latch units (LAT2, LAT4, LAT6, LAT8) connected in series; and

   **characterized by** comprising a selector (54,64) receiving in parallel a data output of the odd latch units and a data output of the even latch units, to selectively output data of the odd latch units or the even latch units to a corresponding output driver (14) on the basis of the state of the test clock.

2. The semiconductor memory device of claim 1, wherein the at least one test mode controller comprises at least one switching element (32;42,46) controlled by a test mode control signal activated when the memory device enters the direct access test mode.

3. The semiconductor memory device of claim 2, wherein the at least one switching element is a tri-state buffer.

4. The semiconductor memory device of claim 2, wherein the at least one switching element is a transmission gate.

5. The semiconductor memory device of claim 2, wherein the at least one test mode controller comprises at least one transistor (34;44,48) having a gate driven by an inversion of the test mode control signal, a drain connected to an input line of the i+1th pipe line block, and a source connected to a supply line.

6. The semiconductor memory device of any preceding claim, wherein each of the pipe line blocks comprises a multiplicity of latches (LAT) which are connected in series, for latching and outputting said data output by the memory blocks.

7. The semiconductor memory device of claim 6, each of the latch units (LAT) comprising:

   a latch (LT) for storing data of the memory blocks and outputting the stored data in response to the activation of a test read signal;
   a multiplexer (MUX) for selectively outputting data generated by the latch or data received by another latch unit in response to the test read signal; and,
   a flipflop (F/F) for outputting data output by the multiplexer, synchronized with a test clock.

8. The semiconductor memory device of claim 1, wherein the selector (54,64) comprises a multiplexer for selectively outputting data output by the odd and even latch units, in response to the test clock.

9. The semiconductor memory device of claim 1, each of the latch units (LAT) comprising:

   a latch (LT) for storing data of the memory block and outputting the stored data in response to the activation of the test read signal;
   a multiplexer (MUX) for selectively outputting data output by the latch or data of another latch unit, in response to the state of the test read signal; and,
   a flipflop (F/F) for outputting data output by the multiplexer, synchronized with the test clock.

10. The semiconductor memory device of any of claims 2 to 4, wherein the at least one test mode controller (40) comprises two switching elements (42,46) connected in series to even latch units and odd latch units, respectively, controlled by a test mode control signal activated when the memory device enters the direct access test mode.

11. Use of a semiconductor memory device according to any preceding claim having said N memory blocks, said N pipe line blocks and said N pipe line blocks, where N is a natural number, for receiving said multiplicity of data output by the memory blocks and sequentially outputting the received data, the use comprising the steps of:

> outputting data of said N memory blocks to said N pipe line blocks, respectively;
> outputting data of said ith memory block, where i is a natural number smaller than N;
> transmitting data of said ith pipe line block to the (i+1)th pipe line block; and
> outputting data from the (i+1)th pipe line block.

**Patentansprüche**

1. Halbleiterspeichervorrichtung umfassend:

> N Speicherblöcke (10, 20), wo N eine natürliche Zahl ist;
> N Fließbandblöcke (52, 62) zum Empfangen einer Mehrzahl von Datenoutput (RWD1 ... RWD8) parallel durch die Speicherblöcke, so dass die Daten seriell ausgegeben werden;
> N Ausgabetreiber (14) zum Übertragen von Datenoutput von den Fließbandblöcken an Datenoutputpins (DQ1, DQ2); und
> mindestens eine Testmodussteuerung (40) zum Verbinden einer Outputleitung eines iten Fließbandblocks (52) mit einer Inputleitung eines (i + 1)ten Fließbandblocks (62), wo i eine natürliche Zahl kleiner als N ist, so dass Datenoutput durch den iten Fließbandblock (52) vom (i + 1)ten Fließbandblock (62) empfangen wird, synchronisiert mit einem Testtakter (TCLK), wenn die Speichervorrichtung in einen Direktzugrifftestmodus eintritt;

> worin jeder der Fließbandblöcke (52, 62) umfasst:

> eine Mehrzahl von ungeraden Latcheinheiten (LAT1, LAT3, LAT5, LAT7), die in Serie verbunden sind;
> eine Mehrzahl von geraden Latcheinheiten (LAT2, LAT4 LAT6, LAT8), die in Serie verbunden sind; und

> **dadurch gekennzeichnet, dass** sie umfasst: einen Selektor (54, 64), der parallel einen Datenoutput der ungeraden Latcheinheiten empfängt und einen Datenoutput der geraden Latcheinheiten, so dass Daten der ungeraden Latcheinheiten oder der geraden Latcheinheiten auf Basis des Zustands des Testtakters selektiv an einen entsprechenden Ausgabetreiber (14) ausgegeben werden.

2. Halbleiterspeichervorrichtung nach Anspruch 1, worin die mindestens eine Testmodussteuerung mindestens ein Schaltelement (32; 42, 46) umfasst, das von einem Testmodussteuersignal gesteuert wird, das aktiviert wird, wenn die Speichervorrichtung in den Direktzugrifftestmodus eintritt.

3. Halbleiterspeichervorrichtung nach Anspruch 2, worin das mindestens eine Schaltelement ein Dreizustandspuffer ist.

4. Halbleiterspeichervorrichtung nach Anspruch 2, worin das mindestens eine Schaltelement ein Transmissionsgate ist.

5. Halbleiterspeichervorrichtung nach Anspruch 2, worin die mindestens eine Testmodussteuerung mindestens einen Transistor (34; 44, 48) umfasst, der ein Gate aufweist, das durch eine Inversion des Testmodussteuersignals betrieben wird, einen Drain, der mit einer Inputleitung des i + 1 ten Fließbandblocks verbunden ist und eine Source, die mit einer Zufuhrleitung verbunden ist.

6. Halbleiterspeichervorrichtung nach einem der vorhergehenden Ansprüche, worin jeder Fließbandblock eine Mehrzahl von Latches (LAT) umfasst, die in Serie verbunden sind, zur Latchverbindung und Ausgabe des Datenoutputs durch die Speicherblökke.

7. Halbleiterspeichervorrichtung nach Anspruch 6, wobei jede der Latcheinheiten (LAT) umfasst:

> ein Latch (LT) zum Speichern von Daten der Speicherblöcke und Ausgeben der gespeicherten Daten in Reaktion auf die Aktvierung eines Testlesesignals;
> einen Multiplexer (MUX) zum selektiven Ausgeben von Daten, die durch den Latch erzeugt sind oder Daten, die durch eine andere Latcheinheit empfangen sind, in Reaktion auf das Testlesesignal; und
> ein Flipflop (F/F) zum Ausgeben von Datenoutput durch den Multiplexer, synchronisiert mit einem Testtakter.

8. Halbleiterspeichervorrichtung nach Anspruch 1, worin der Selektor (54, 64) einen Multiplexer umfasst zum selektiven Ausgeben von Datenoutput durch die ungeraden und geraden Latcheinheiten, in Reaktion auf den Testtakter.

9. Halbleiterspeichervorrichtung nach Anspruch 1, worin jede der Latcheinheiten (LAT) umfasst:

ein Latch (LT) zum Speichern von Daten des Speicherblocks und Ausgeben der gespeicherten Daten in Reaktion auf die Aktivierung des Testlesesignals;
einen Multiplexer (MUX) zum selektiven Ausgeben von Datenoutput durch das Latch oder Daten einer anderen Latcheinheit, in Reaktion auf den Zustand des Testlesesignals; und
ein Flipflop (F/F) zum Ausgeben von Datenoutput durch den Multiplexer, synchronisiert mit dem Testtakter.

10. Halbleiterspeichervorrichtung nach einem der Ansprüche 2 bis 4, worin die mindestens eine Testmodussteuerung (40) zwei Schaltelemente (42, 46) umfasst, die in Serie mit geraden Latcheinheiten bzw. ungeraden Latcheinheiten verbunden sind, gesteuert durch ein Testmodussteuersignal, das aktiviert wird, wenn die Speichervorrichtung in den Direktzugriffstestmodus eintritt.

11. Verwendung einer Halbleiterspeichervorrichtung nach einem der vorhergehenden Ansprüche mit den N Speicherblöcken, den N Fließbandblöcken und den N Fließbandblöcken, wo N eine natürliche Zahl ist, zum Empfangen der Mehrzahl von Datenoutput durch die Speicherblöcke und sequentiellen Ausgeben der empfangenen Daten, wobei die Verwendung die Schritte umfasst:

Ausgeben von Daten der N Speicherblöcke jeweils an die N Fließbandblöcke;
Ausgeben von Daten des iten Speicherblocks, wo i eine natürliche Zahl kleiner als N ist;
Übertragen von Daten des iten Fließbandblocks an den (i + 1)ten Fließbandblock; und
Ausgeben von Daten vom (i + 1)ten Fließbandblock.

## Revendications

1. Dispositif de mémoire à semi-conducteurs, comprenant :

♦ N blocs de mémoire (10, 20), N étant un entier naturel ;

♦ N blocs pipeline (52, 62) destinés à recevoir une multitude de sorties de données (RWD1 ... RWDB) envoyées en parallèle par les blocs de mémoire afin de sortir les données en série ;

♦ N pilotes de sortie (14) destinés à transmettre des données sorties des blocs pipeline vers des broches (DQ1, DQ2) de sortie de données ; et

♦ au moins un contrôleur (40) de mode de test, destiné à connecter une ligne de sortie d'un $i^{\text{éme}}$ bloc pipeline (52) à une ligne d'entrée d'un $(i+1)^{\text{ème}}$ bloc pipeline (62), i étant un entier naturel inférieur à N, de telle manière des données sorties par le $i^{\text{ème}}$ bloc pipeline (52) sont reçues par ledit $(i+1)^{\text{ème}}$ bloc pipeline (62), synchronisé avec une horloge de test (TCLK), lorsque le dispositif de mémoire entre dans un mode de test à accès direct ;

dans lequel chacun des blocs pipeline (52, 62) comprend :

♦ une pluralité d'unités de bascule impaires (LAT1, LAT3. LAT5, LAT7) connectées en série ;

♦ une pluralité d'unités de bascule paires (LAT2, LAT4, LAT6, LAT8) connectées en série ; et

♦ **caractérisé en ce qu'**il comprend un sélecteur (54, 64) recevant en parallèle une sortie de données des unités de bascule impaires et une sortie de données des unités de bascule paires, afin de sortir de manière sélective des données des unités de bascule Impaires ou des unités de bascule paires vers un pilote de sortie (14) correspondant, sur la base de l'état de l'horloge de test.

2. Dispositif de mémoire à semi-conducteurs selon la revendication 1, dans lequel le au moins un contrôleur de mode de test comprend au moins un élément de commutation (32 ; 42, 46) commandé par un signal de commande de mode de test activé, lorsque le dispositif de mémoire entre dans le mode de test à accès direct.

3. Dispositif de mémoire à semi-conducteurs selon la revendication 2, dans lequel le au moins un élément de commutation est un tampon à trois états.

4. Dispositif de mémoire à semi-conducteurs selon la revendication 2, dans lequel le au moins un élément de commutation est une porte de transmission.

5. Dispositif de mémoire à semi-conducteurs selon la revendication 2, dans lequel le au moins un contrôleur de mode de test comprend au moins un transistor (34 ; 44, 48) ayant une grille pilotée par une inversion du signal de commande de mode de test, un drain connecté à une ligne d'entrée du $(i+1)^{\text{éme}}$ bloc pipeline et une source connectée à une ligne d'alimentation.

**6.** Dispositif de mémoire à semi-conducteurs selon l'une quelconque des revendications précédentes, dans lequel chacun des blocs pipeline comprend une multitude de bascules (LAT) qui sont connectées en série, destinées à faire basculer et à sortir lesdites données sorties par les blocs de mémoire.

**7.** Dispositif de mémoire à semi-conducteurs selon la revendication 6, chacun des unités de bascule (LAT) comprenant :

- une bascule (LT) destinée à stocker des données des blocs de mémoire et à sortir les données stockées en réponse à l'activation d'un signal de lecture de test ;
- un multiplexeur (MUX) destiné à sortir de manière sélective des données produites par la bascule ou des données reçues par une autre unité de bascule en réponse au signal de lecture de test ; et
- une bascule bistable (F/F) destinée à sortir des données sorties par le multiplexeur, synchronisé avec une horloge de test.

**8.** Dispositif de mémoire à semi-conducteurs selon la revendication 1, dans lequel le sélecteur (54, 64) comprend un multiplexeur destiné à sortir de manière sélective des données sorties par les unités de bascule impaires et paires, en réponse à l'horloge de test

**9.** Dispositif de mémoire à semi-conducteurs selon la revendication 1, chacune des unités de bascule (LAT) comprenant :

- une bascule (LT) destinée à stocker des données du bloc de mémoire et à sortir les données stockées en réponse à l'activation du signal de lecture de test ;
- un multiplexeur (MUX) destiné à sortir de manière sélective des données produites par la bascule ou des données d'une autre unité de bascule, en réponse à l'état du signal de lecture de test ; et
- une bascule bistable (F/F) destinée à sortir des données sorties par le multiplexeur, synchronisé avec l'horloge de test

**10.** Dispositif de mémoire à semi-conducteurs selon l'une quelconque des revendications 2 à 4, dans lequel le au moins un contrôleur (40) de mode de test comprend deux éléments de commutation (42, 46) connectés en série à des unités de bascule paires et à des unités de bascule impaires, respectivement, commandés par un signal de commande de mode de test activé lorsque le dispositif de mémoire entre dans le mode de test à accès direct.

**11.** Utilisation d'un dispositif de mémoire à semi-conducteurs selon l'une quelconque des revendications précédentes, ayant lesdits N blocs de mémoire et lesdits N blocs pipeline, N étant un entier naturel, destinés à recevoir ladite multitude de données sorties par les blocs de mémoire et à sortir de manière séquentielle les données reçues, l'usage comprenant les étapes suivantes :

- sortir des données desdits N blocs de mémoire vers lesdits N blocs pipeline, respectivement ;
- sortir des données dudit $i^{ème}$ bloc de mémoire, i étant un entier naturel inférieur à N ;
- transmettre des données dudit $i^{ème}$ bloc pipeline vers le $(i+1)^{ème}$ bloc pipeline ; et
- sortir des données du $(i+1)^{ème}$ bloc pipeline.

# FIG. 1

EP 0 921 528 B1

# FIG. 2

EP 0 921 528 B1

# FIG. 3

EP 0 921 528 B1

# FIG. 4

øDAE

"H"

$\overline{TRAS}$

$\overline{TCAS}$

TWE

RWD     READ DATA

øTRL

TCLK

DQ

RADR    CADR

EP 0 921 528 B1

# FIG. 5

EP 0 921 528 B1